# EUROPEAN PATENT APPLICATION

(11) **EP 2 881 989 A1**
(43) Date of publication of application: **10.06.2015**
(21) Application number: 14195594.8
(22) Date of filing: 01.12.2014
(51) Int. Cl.: H01L 27/02, H02H 9/04, H03K 17/081, H01L 27/088

(54) **Composite power device with ESD protection clamp**

(30) Priority: 09.12.2013 US 201361913533 P; 25.11.2014 US 201414553419
(71) Applicant: International Rectifier Corporation, El Segundo, CA 90245 (US)
(72) Inventor: Briere, Michael A., Scottsdale, AZ Arizona 85266 (US)
(74) Representative: Dr. Weitzel & Partner

(57) **Abstract**

There are disclosed herein various implementations of a normally off (enhancement mode) composite power device with an ESD protection clamp. Such a normally off composite power device includes a normally on (depletion mode) power transistor providing a composite drain of the normally off composite power device, and a normally off low voltage (LV) transistor cascoded with the normally on power transistor. The normally off LV transistor provides a composite source and a composite gate of the normally off composite power device. The normally off composite power device also includes the ESD protection clamp coupled between the composite source and the composite gate. The ESD protection clamp is configured to provide electrostatic discharge (ESD) protection for the normally off composite power device.

## Description

### BACKGROUND

The present application claims the benefit of and priority to a provisional application entitled "III-Nitride Transistor Cascoded with Diode Protected Silicon MOSFET," Serial No. 61/913,533 filed on December 9, 2013. The disclosure in this provisional application is hereby incorporated fully by reference into the present application.

### I. DEFINITION

As used herein, the phrase "group III-V" refers to a compound semiconductor including at least one group III element and at least one group V element. By way of example, a group III-V semiconductor may take the form of a III-Nitride semiconductor. "III-Nitride" or "III-N" refers to a compound semiconductor that includes nitrogen and at least one group III element such as aluminum (Al), gallium (Ga), indium (In), and boron (B), and including but not limited to any of its alloys, such as aluminum gallium nitride (AlₓGa₍₁₋ₓ₎N), indium gallium nitride (In_{y}Ga_{(1-y)}N), aluminum indium gallium nitride (AlₓIn_{y}Ga_{(1-x-y)}N), gallium arsenide phosphide nitride (GaAsₐP_{b}N_{(1-a-b)}), aluminum indium gallium arsenide phosphide nitride (AlₓIn_{y}Ga_{(1-x-y)}ASₐP_{b}N_{(1-a-b)}), for example. III-N also refers generally to any polarity including but not limited to Ga-polar, N-polar, semi-polar, or non-polar crystal orientations. A III-N material may also include either the Wurtzitic, Zincblende, or mixed polytypes, and may include single-crystal, monocrystalline, polycrystalline, or amorphous structures. Gallium nitride or GaN, as used herein, refers to a III-N compound semiconductor wherein the group III element or elements include some or a substantial amount of gallium, but may also include other group III elements in addition to gallium.

In addition, as used herein, the phrase "group IV" refers to a semiconductor that includes at least one group IV element such as silicon (Si), germanium (Ge), and carbon (C), and may also include compound semiconductors such as silicon germanium (SiGe) and silicon carbide (SiC), for example. Group IV also refers to semiconductor materials which include more than one layer of group IV elements, or doping of group IV elements to produce strained group IV materials, and may also include group IV based composite substrates such as single-crystal or polycrystalline SiC on silicon, silicon on insulator (SOI), separation by implantation of oxygen (SIMOX) process substrates, and silicon on sapphire (SOS), for example.

It is noted that, as used herein, the terms "low voltage" or "LV" in reference to a transistor or switch describes a transistor or switch with a voltage range of up to approximately fifty volts (50V). It is further noted that use of the term "midvoltage" or "MV" refers to a voltage range from approximately fifty volts to approximately two hundred volts (approximately 50V to 200V). Moreover, the term "high voltage" or "HV," as used herein, refers to a voltage range from approximately two hundred volts to approximately twelve hundred volts (approximately 200V to 1200V), or higher.

### II. BACKGROUND ART

In power management applications where normally off characteristics of power devices are advantageous, a depletion mode (normally on) power transistor having desirable on-state characteristics, such as a low on-resistance, can be implemented in combination with a low voltage (LV) enhancement mode (normally off) transistor to produce an enhancement mode composite power switch. For example, a III-Nitride or other group III-V power field-effect transistor (FET) or high electron mobility transistor (HEMT) may be implemented in combination with an LV silicon FET to provide a high performance composite switch.

Careful selection of the power transistor and LV transistor used to form the composite switch can result in a rugged switch capable in principle of tolerating high noise and high voltage spike environments. However, in conventional implementations, the gate of the LV enhancement mode transistor typically remains susceptible to damage as a result of an electrostatic discharge (ESD) event. Consequently, conventional composite power switches can be vulnerable to premature failure due to ESD caused damage, which may be incurred during device fabrication and assembly, for example.

### SUMMARY

The present disclosure is directed to a composite power device with ESD protection clamp, substantially as shown in and/or described in connection with at least one of the figures, and as set forth more completely in the claims.

### BRIEF DESCRIPTION OF THE DRAWINGS

Figure 1 shows a diagram of a normally off (enhancement mode) composite power switch, according to a conventional implementation.
Figure 2 shows a diagram of a normally off (enhancement mode) composite power device including an ESD protection clamp, according to one exemplary implementation.
Figure 3 shows a diagram of a normally off (enhancement mode) composite power device including an ESD protection clamp, according to another exemplary implementation.
Figure 4 shows a diagram of a normally off (enhancement mode) composite power device including an ESD protection clamp, according to yet another exemplary implementation.

### DETAILED DESCRIPTION

The following description contains specific information pertaining to implementations in the present disclosure. One skilled in the art will recognize that the present disclosure may be implemented in a manner different from that specifically discussed herein. The drawings in the present application and their accompanying detailed description are directed to merely exemplary implementations. Unless noted otherwise, like or corresponding elements among the figures may be indicated by like or corresponding reference numerals. Moreover, the drawings and illustrations in the present application are generally not to scale, and are not intended to correspond to actual relative dimensions.

As noted above, in power management applications where normally off characteristics of power devices are advantageous, a depletion mode (normally on) power transistor having desirable on-state characteristics, such as a low on-resistance, can be implemented in combination with a low voltage (LV) enhancement mode (normally off) transistor to produce an enhancement mode composite power switch. For example, a III-Nitride or other group III-V power field-effect transistor (FET) or high electron mobility transistor (HEMT) may be implemented in combination with an LV silicon FET to provide a high performance composite switch.

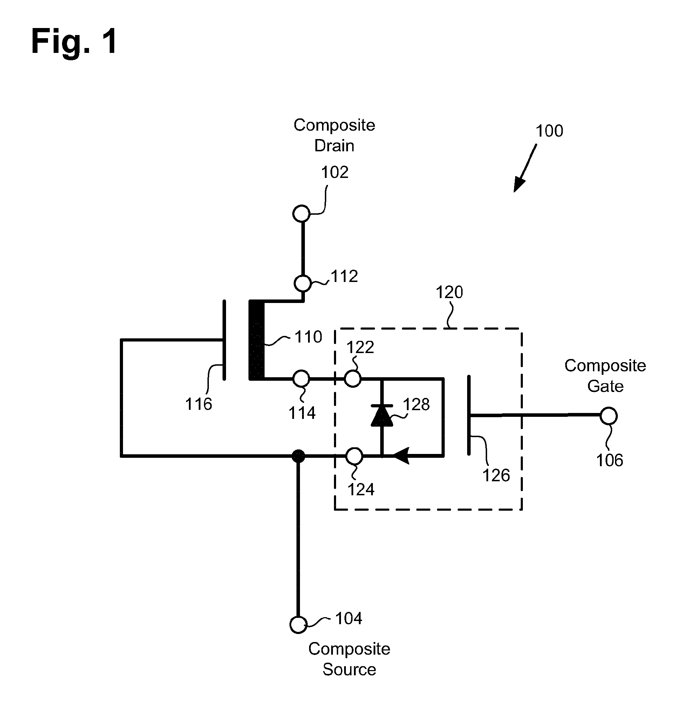

Figure 1 shows a diagram of a conventional implementation of such a normally off composite power switch. Conventional composite power switch 100 includes III-Nitride power transistor 110, which may be a normally on (depletion mode) transistor, and LV silicon transistor 120, which is typically a normally off (enhancement mode) transistor. As shown in Figure 1, III-Nitride power transistor 110 is shown as a FET having drain 112, source 114, and gate 116, while LV silicon transistor 120 is shown as a FET having drain 122, source 124, and gate 126, and also including body diode 128.

As further shown in Figure 1, LV silicon transistor 120 is cascoded with III-Nitride power transistor 110 to provide conventional composite power switch 100 having composite drain 102, composite source 104, and composite gate 106. In other words, the cascoded combination of III-Nitride power transistor 110 and LV silicon transistor 120 produces composite power switch 100, which according to the implementation shown in Figure 1 results in a composite three terminal device functioning in effect as a FET. Moreover, the conventional implementation show in Figure 1 allows for the use of LV silicon transistor 120 to control the flow of current through conventional composite power switch 100 using several advantages of LV silicon transistor 120, including well established robust reliable gate drive behavior.

Several examples of such cascoded III-Nitride switches are disclosed in U.S. Patent Number 8,017,978, entitled "Hybrid Semiconductor Device", filed on March 10, 2006, and issued on September 13, 2011; U.S. Patent Number 8,084,783, entitled "GaN-Based Device Cascoded with an Integrated FET/Schottky Diode Device", filed on November 9, 2009, and issued on December 27, 2011; U.S. Patent Application Number 13/433,864, entitled "Stacked Composite Device Including a Group III-V Transistor and a Group IV Lateral Transistor", filed on March 29, 2012, and published as U.S. Patent Application Publication Number 2012/0256188 on October 11, 2012; U.S. Patent Application Number 13/434,412, entitled "Stacked Composite Device Including a Group III-V Transistor and a Group IV Vertical Transistor", filed on March 29, 2012, and published as U.S. Patent Application Publication Number 2012/0256189 also on October 11, 2012; and U.S. Patent Application Number 13/780,436, entitled "Group III-V and Group IV Composite Switch", filed on February 28, 2013, and published as U.S. Patent Application Publication Number 2013/0240898 on September 19, 2013. The above identified patents and patent applications are hereby incorporated fully by reference into the present application.

In order to make conventional composite power switch 100 capable of operating reliably in power management systems, where there are typically high noise and high voltage spikes present, the cascode configuration shown in Figure 1 needs to be highly optimized. That is to say, the relative sizes of III-Nitride power transistor 110 and LV silicon transistor 120, their respective device characteristics (such as device breakdown, device transconductance, input and output capacitances, gate resistance, and the like), and parasitics associated with their packaging should be optimized.

Examples of a cascoded device incorporating such optimization are disclosed in U.S. Patent Number 8,766,375, entitled "Composite Semiconductor Device with Active Oscillation Prevention" filed on March 9, 2012, and issued on July 1, 2014; U.S Patent Application Number 13/419,820, entitled "III-Nitride Transistor with Passive Oscillation Prevention", filed on March 14, 2012, and published as U.S. Patent Application Publication Number 2012/0241820 on September 27, 2012; U.S. Patent Application Number 13/415,779, entitled "Composite Semiconductor Device with Turn-On Prevention Control", filed on March 8, 2012 and published as U.S. Patent Application Publication Number 2012/0241819 also on September 27, 2012; and U.S. Patent Application Number 13/416,252, entitled "High Voltage Composite Semiconductor Device with Protection for a Low Voltage Device", filed on March 9, 2012, and published as U.S. Patent Application Publication Number 2012/0241756 also on September 27, 2102. The above identified patent and patent applications are hereby incorporated fully by reference into the present application.

Despite the advantages provided by conventional composite power switch 100, gate 126 of LV silicon transistor 120 typically remains susceptible to damage as a result of an electrostatic discharge (ESD) event. As a result, composite gate 106 provided by gate 126 of LV silicon transistor is susceptible to such damage, rendering conventional composite power switch 100 vulnerable to premature failure due to ESD induced damage, which may be experienced during device fabrication and/or assembly and/or packaged product handling, for example.

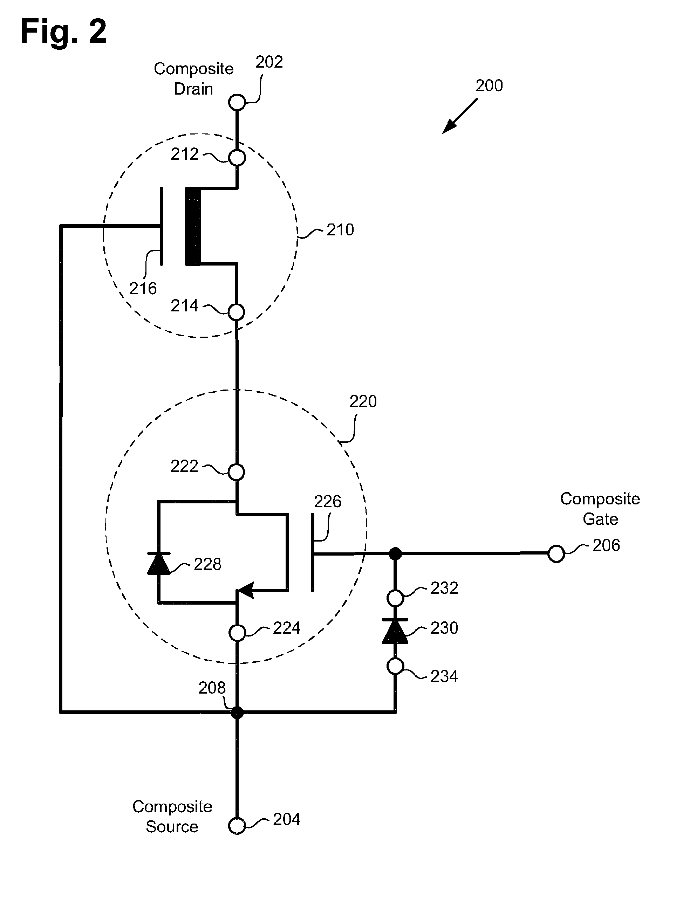

The present application is directed to implementations of normally off (enhancement mode) composite power devices configured so as to reduce or substantially prevent ESD induced damage. In various implementations, an ESD protection clamp may be utilized to protect a gate of an LV transistor, and thus the composite gate of the composite power device that is provided by the gate of the LV transistor, from ESD related damage or failure. Figures 2, 3, and 4, described below, disclose respective exemplary implementations of such a composite power device including an ESD protection clamp.

Referring to Figure 2, Figure 2 shows a diagram of normally off (enhancement mode) composite power device 200 including ESD protection clamp 230, according to one exemplary implementation. ESD protection clamp 230 is represented by a general diode symbol for the purpose of ease of drawing illustration in the present application. However, ESD protection clamp 230 can be any ESD protection clamp known in the art. For example, resistors, various transistors (typically bipolar transistors), silicon controlled rectifiers (SCRs)" PN diodes, PIN diodes, Shottkey diodes and/or Zener diodes can be used in various combinations to form ESD protection clamp 230. ESD protection clamp 230 is in general a two terminal clamp, with one terminal being coupled to a composite source of the composite power device, in this example to composite source 204 of composite power device 200. This terminal is referred to as an "anode" terminal, in this case anode 234. Another terminal of the two terminal clamp is coupled to a composite gate of the composite power device, in this case to composite gate 206 of composite power device 200. This terminal is referred to as the "cathode" terminal, in this case cathode 232. Thus, the terms anode and cathode are used to designate the two terminals of the ESD protection clamp, and are not limited to anode and cathode terminals of a diode, which is used for ease of illustration in drawings of the present application.

As shown in Figure 2, in addition to ESD protection clamp 230 having cathode 232 and anode 234, composite power device 200 includes normally on (depletion mode) power transistor 210, and normally off LV transistor 220 cascoded with normally on power transistor 210. Also shown in Figure 2 are composite drain 202, composite source 204, and composite gate 206 of composite power device 200, as well as drain 212, source 214, and gate 216 of normally on power transistor 210, and drain 222, source 224, gate 226, and body diode 228 of normally off LV transistor 220.

It is noted that, in high power and high performance circuit applications, group III-V transistors, such as transistors fabricated from III-Nitride materials, are often desirable for their high efficiency and high voltage handling capability. As noted above in the Definition section, III-Nitride materials include, for example, gallium nitride (GaN) and its alloys such as aluminum gallium nitride (AlGaN), indium gallium nitride (InGaN), and aluminum indium gallium nitride (AlInGaN). These III-Nitride materials are semiconductor compounds having a relatively wide, direct bandgap and can enable high breakdown fields, and the creation of a two-dimensional electron gas (2DEG) that exhibits high conduction electron mobility. As a result, III-Nitride materials such as GaN are used in many microelectronic applications as depletion mode power FETs and HEMTs.

Normally on power transistor 210 may be such a III-Nitride or other group III-V based power transistor, and may be implemented as a depletion mode insulated-gate FET (IGFET), a junction FET (JFET), an accumulation mode FET (AccuFet), or as a heterostructure FET (HFET) or HEMT, for example. In one implementation, normally on power transistor 210 may take the form of a depletion mode metal-insulator-semiconductor HFET (MISHFET), such as a metal-oxide-semiconductor HFET (MOSHFET). According to one implementation, for example, normally on power transistor 210 may be a high voltage (HV) transistor, as defined above in the Definition section of the present application. Thus, normally on power transistor 210 can take the form of an HV group III-V transistor such as an HV group III-V FET or HEMT.

Normally off LV transistor 220 may be implemented as an enhancement mode LV group IV transistor, such as an enhancement mode silicon transistor, for example. According to one implementation, normally off LV transistor 220 may be a silicon MISFET or MOSFET. However, in other implementations, normally off LV transistor 220 may include any suitable group IV material, such as silicon carbide (SiC), germanium (Ge), silicon germanium (SiGe), or a strained group IV element or compound, for example. In some implementations, as shown in Figure 2, normally off LV transistor 220 may include body diode 228 coupled across source 224 and drain 222 of normally off LV transistor 220.

The combination of normally on power transistor 210 and normally off LV transistor 220 provides composite power device 200, which according to the implementation shown in Figure 2 can be configured as a composite three terminal device functioning in effect as a normally off (enhancement mode) composite power transistor having composite drain 202 provided by normally on power transistor 210, and composite source 204 and composite gate 206 provided by normally off LV transistor 220. Moreover, and in contrast to conventional implementations, composite power device 200 further includes ESD protection clamp 230 configured to provide ESD protection for normally off composite power device 200.

In some implementations, ESD protection clamp 230 may be a group IV diode, such as a silicon PN junction diode, for example. According to the exemplary implementations shown in Figure 2, ESD protection clamp 230 may be a discrete clamping element that is not monolithically integrated on a common die with either of normally off LV transistor 220 or normally on power transistor 210. In such implementations, normally off composite power device 200 may be assembled using die stacking techniques as disclosed in U.S. Patent Number 8,847,408, entitled "III-Nitride Transistor Stacked with FET in a Package", filed on March 22, 2011, and issued on September 30, 2014; U.S. Patent Application Number 13/053,646 filed on March 22, 2011, entitled "III-Nitride Transistor Stacked with Diode in a Package"; U.S. Patent Application Number 13/433,864 filed on March 29, 2012, entitled "Stacked Composite Device Including a Group III-V Transistor and a Group IV Lateral Transistor"; U.S. Patent Application Number 13/434,412 filed on March 29, 2012, entitled "Stacked Composite Device Including a Group III-V Transistor and a Group IV Vertical Transistor"; U.S. Patent Application Number 13/434,524 filed on March 29, 2012, entitled "Stacked Composite Device Including a Group III-V Transistor and a Group IV Diode"; U.S. Patent Application Number 13/780,436 filed on February 28, 2013, entitled "Group III-V and Group IV Composite Switch; and U.S. Patent Application Number 13/781,080 filed on February 28, 2013, entitled "Group III-V and Group IV Composite Diode." The disclosures in all of the above-identified patent and patent application documents are hereby incorporated fully by reference into the present application.

As shown in Figure 2, ESD protection clamp 230 may be coupled between composite source 204 and composite gate 206 of composite power device 200. As further shown in Figure 2, drain 222 of normally off LV transistor 220 is coupled to source 214 of normally on power transistor 210, source 224 of normally off LV transistor 220 provides composite source 204, and gate 226 normally off LV transistor 220 provides composite gate 206. In addition, drain 212 of normally on power transistor 210 provides composite drain 202, while gate 216 of normally on power transistor 210 is coupled to source 224 of normally off LV transistor 220 and to anode 234 of ESD protection clamp 230 at node 208. According to the present implementation, cathode 232 of ESD protection clamp 230 is coupled to gate 226 of normally off LV transistor providing composite gate 206.

In various implementations of the present disclosure, ESD protection clamp 230 is configured such that the sum of the breakdown voltage of ESD protection clamp 230 and the current-resistance (IR) drop across ESD protection clamp 230 during an ESD event is less than the breakdown voltage of gate 226 of normally off LV transistor 220. At the same time, the breakdown voltage of the ESD protection clamp 230 is designed to be greater than the maximum rated operating voltage of gate 226. In various implementations of the present disclosure, ESD protection clamp 230 is configured such that normally off composite power device 200 is capable of surviving ESD test standards as characterized by the Human-Body Model (HBM) and Machine Model (MM), as known in the art. For example, ESD protection clamp may be configured to enable normally off composite power device 200 to survive HBM of greater than or approximately equal to 2kV and to survive MM of greater than or approximately equal to 500V. The present disclosure is in marked contrast to previously used gate protection schemes for III-V devices, where a protection diode or a protection clamp may have been utilized to protect against voltage spikes which exceed the safe operation of the group III-V device gate generated by a gate driver coupled to the composite gate of the composite power device. For example, the gate driver protection scheme is generally limited to protection against voltages up to about 10 volts. However, the ESD protection clamp of the present disclosure protects against much higher voltages from 500 volts to about 2000 volts, as stated above, though the clamping voltage is designed to be less than the safe dielectric capability of the LV enhancement mode device gate, typically less than 20 volts. It is noted that ESD protection clamp 230 may not be implemented as a single component, but rather may include several components, as discussed above, in order to meet the design requirements described above.

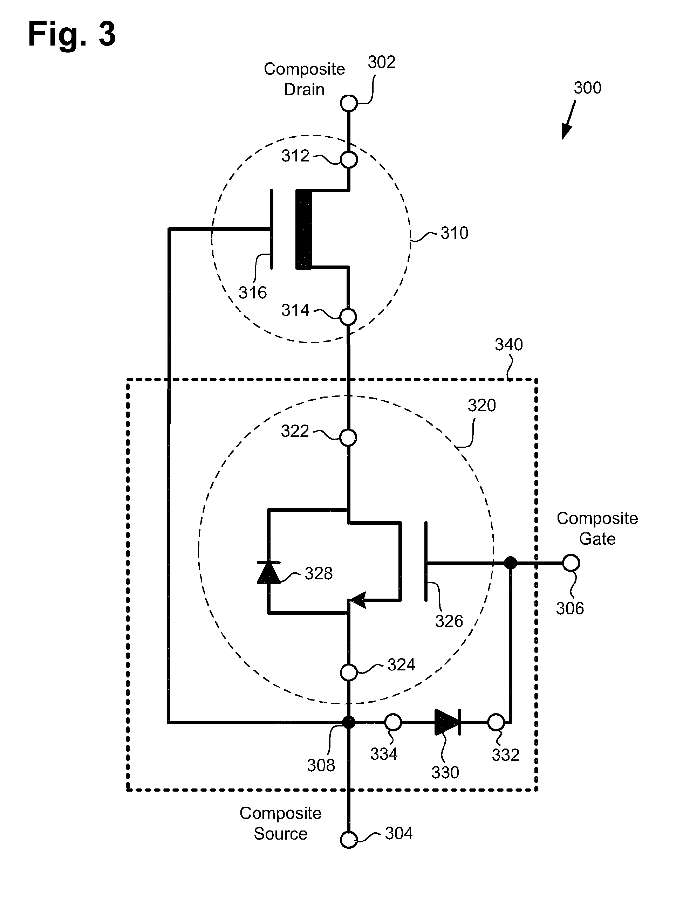

Continuing to Figure 3, Figure 3 shows a diagram of normally off (enhancement mode) composite power device 300 including ESD protection clamp 330, according to another exemplary implementation. ESD protection clamp 330 is represented by a general diode symbol for the purpose of ease of drawing illustration in the present application. However, ESD protection clamp 330 can be any ESD protection clamp known in the art. For example, resistors, various transistors (typically bipolar transistors), silicon controlled rectifiers (SCRs), PN diodes, PIN diodes, Shottkey diodes and/or Zener diodes can be used in various combinations to form ESD protection clamp 330. ESD protection clamp 330 is in general a two terminal clamp, with one terminal being coupled to a composite source of the composite power device, in this example to composite source 304 of composite power device 300. This terminal is referred to as an "anode" terminal, in this case anode 334. Another terminal of the two terminal clamp is coupled to a composite gate of the composite power device, in this case to composite gate 306 of composite power device 300. This terminal is referred to as the "cathode" terminal, in this case cathode 332. Thus, the terms anode and cathode are used to designate the two terminals of the ESD protection clamp, and are not limited to anode and cathode terminals of a diode, which is used for ease of illustration in drawings of the present application.

As shown in Figure 3, in addition to ESD protection clamp 330 having cathode 332 and anode 334, composite power device 300 includes normally on (depletion mode) power transistor 310, and normally off LV transistor 320 cascoded with normally on power transistor 310. Also shown in Figure 3 are composite drain 302, composite source 304, and composite gate 306 of composite power device 300, as well as drain 312, source 314, and gate 316 of normally on power transistor 310, and drain 322, source 324, gate 326, and body diode 328 of normally off LV transistor 320. In addition, Figure 3 shows die 340 common to normally off LV transistor 320 and ESD protection clamp 330, and node 308 through which gate 316 of normally on power transistor 310 is coupled to source 324 of normally off LV transistor 320 and to anode 334 of ESD protection clamp 330.

Composite power device 300 including normally on power transistor 310, normally off LV transistor 320, and ESD protection clamp 330 corresponds in general to composite power device 200 including normally on power transistor 210, normally off LV transistor 220, and ESD protection clamp 230, in Figure 2. As a result, composite power device 300, normally on power transistor 310, normally off LV transistor 320, and ESD protection clamp 330 can share the characteristics attributed to their respective corresponding features, above.

However, in contrast to the implementation shown in Figure 2, according to the implementation shown in Figure 3, ESD protection clamp 330 is monolithically integrated with normally off LV transistor 320. As depicted in Figure 3, normally off LV transistor 320 and ESD protection clamp 330 may each be implemented as group IV devices, such as silicon devices, and may be monolithically integrated on common die 340. Moreover, in some implementations, it may be advantageous or desirable to form ESD protection clamp 330 from doped regions on common die 340 similar to doped regions on common die 340 used to form source 324 and drain 322 of normally off LV transistor 320. Monolithic integration of the ESD protection clamp 330 with LV transistor 320 provides protection from damage due to ESD events during wafer level and die level handling and packaging operations. Further, by monolithically integrating ESD protection clamp 330 with normally off LV transistor 320 on common die 340, the size of ESD protection clamp 330 can be substantially minimized, thereby reducing gate capacitance and leakage

As noted above, in various implementations of the present disclosure, ESD protection clamp 330 is configured such that the sum of the breakdown voltage of ESD protection clamp 330 and the IR drop across ESD protection clamp 330 during an ESD event is less than the breakdown voltage of gate 326 of normally off LV transistor 320. At the same time, the breakdown voltage of ESD protection clamp 330 is designed to be greater than the maximum rated operating voltage of gate 326. In various implementations of the present disclosure, ESD protection clamp 330 is configured such that normally off composite power device 300 is capable of surviving ESD test standards as characterized by HBM of greater than or approximately equal to 2kV and to MM of greater than or approximately equal to 500V. It is noted that ESD protection clamp 330 may not be implemented as a single component, but rather may include several components, as discussed above, in order to meet the design requirements described above.

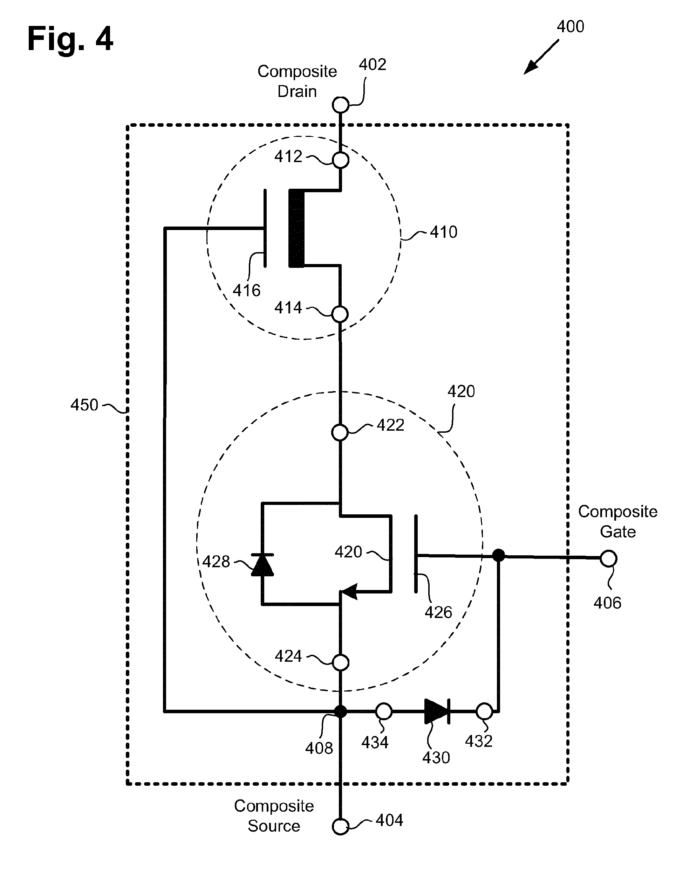

Moving to Figure 4, Figure 4 shows a diagram of normally off (enhancement mode) composite power device 400 including ESD protection clamp 430, according to yet another exemplary implementation. ESD protection clamp 430 is represented by a general diode symbol for the purpose of ease of drawing illustration in the present application. However, ESD protection clamp 430 can be any ESD protection clamp known in the art. For example, resistors, various transistors (typically bipolar transistors), silicon controlled rectifiers (SCRs), PN diodes, PIN diodes, Shottkey diodes and/or Zener diodes can be used in various combinations to form ESD protection clamp 430. ESD protection clamp 430 is in general a two terminal clamp, with one terminal being coupled to a composite source of the composite power device, in this example to composite source 404 of composite power device 400. This terminal is referred to as an "anode" terminal, in this case anode 434. Another terminal of the two terminal clamp is coupled to a composite gate of the composite power device, in this case to composite gate 406 of composite power device 400. This terminal is referred to as the "cathode" terminal, in this case cathode 432. Thus, the terms anode and cathode are used to designate the two terminals of the ESD protection clamp, and are not limited to anode and cathode terminals of a diode, which is used for ease of illustration in drawings of the present application.

As shown in Figure 4, in addition to ESD protection clamp 430 having cathode 432 and anode 434, composite power device 400 includes normally on (depletion mode) power transistor 410, and normally off LV transistor 420 cascoded with normally on power transistor 410. Also shown in Figure 4 are composite drain 402, composite source 404, and composite gate 406 of composite power device 400, as well as drain 412, source 414, and gate 416 of normally on power transistor 410, and drain 422, source 424, gate 426, and body diode 428 of normally off LV transistor 420. In addition, Figure 4 shows die 450 common to normally on power transistor 410, normally off LV transistor 420, and ESD protection clamp 430, and node 408 through which gate 416 of normally on power transistor 410 is coupled to source 424 of normally off LV transistor 420 and to anode 434 of ESD protection clamp 430.

Composite power device 400 including normally on power transistor 410, normally off LV transistor 420, and ESD protection clamp 430 corresponds in general to composite power device 200 including normally on power transistor 210, normally off LV transistor 220, and ESD protection clamp 230, in Figure 2. As a result, composite power device 400, normally on power transistor 410, normally off LV transistor 420, and ESD protection clamp 430 can share the characteristics attributed to their respective corresponding features, above.

However, in contrast to the implementation shown in Figure 2, according to the implementation shown in Figure 4, ESD protection clamp 430 is monolithically integrated with both normally off LV transistor 420 and normally on power transistor 410. As depicted in Figure 4, normally on power transistor 410, normally off LV transistor 420, and ESD protection clamp 430 may be monolithically integrated on common die 450.

Exemplary techniques for integrating cascoded III-Nitride and silicon based switches are described in U.S. Patent Number 7,915,645, entitled "Monolithic Vertically Integrated Composite Group III-V and Group IV Semiconductor Device and Method For Fabricating Same", filed on May 28, 2009, and issued on March 29, 2011; U.S. Patent Application Number 14/472,974, filed on August 29, 2014, entitled "Monolithic Integrated Composite Group III-V and Group IV Semiconductor Device and IC"; U.S. Patent Application Number 12/653,236, filed on December 10, 2009, entitled "Monolithic Integrated Composite Group III-V and Group IV Semiconductor Device and Method for Fabricating Same"; U.S. Patent Application Number 12/174,329, filed on July 16, 2008, entitled "III-Nitride Device"; U.S. Patent Application Number 11/999,552, filed on December 4, 2007, entitled "Monolithically Integrated III-Nitride Power Converter," and issued as U.S. Patent Number 7,863,877 on January 4, 2011; U.S. Patent Application Number 12/928,103, filed on December 3, 2010, entitled "Monolithic Integration of Silicon and Group III-V Devices"; and U.S. Patent Application Number 14/327,495, filed on July 9, 2014, entitled "Monolithic Composite III-Nitride Transistor with High Voltage Group IV Enable Switch." The disclosures in all of the above-identified patent and patent application documents are hereby incorporated fully by reference into the present application.

As noted above, in various implementations of the present disclosure, ESD protection clamp 430 is configured such that the sum of the breakdown voltage of ESD protection clamp 430 and the IR drop across ESD protection clamp 430 during an ESD event is less than the breakdown voltage of gate 426 of normally off LV transistor 420. At the same time, the breakdown voltage of ESD protection clamp 430 is designed to be greater than the maximum rated operating voltage of gate 426. In various implementations of the present disclosure, ESD protection clamp 430 is configured such that normally off composite power device 400 is capable of surviving ESD test standards as characterized by HBM of greater than or approximately equal to 2kV and to MM of greater than or approximately equal to 500V. It is noted that ESD protection clamp 430 may not be implemented as a single component, but rather may include several components, as discussed above, in order to meet the design requirements described above.

From the above description it is manifest that various other implementations of the present inventive concepts are also possible without departing from the scope of those concepts. For example, in some implementations, the normally on power transistor and the normally off LV transistor may be monolithically integrated on a common die, while the ESD protection clamp may be implemented as a discrete diode not monolithically integrated with either transistor.

Thus, the present application discloses normally off (enhancement mode) composite power devices configured so as to reduce or substantially prevent ESD related damage. In various implementations of the present disclosure, an ESD protection clamp may be utilized to protect a gate of a normally off LV transistor, and thus protect the composite gate of the composite power device from ESD related damage or failure Monolithic integration of the ESD protection clamp 330 with LV transistor 320 provides protection from damage due to ESD events during wafer level and die level handling and packaging operations. Moreover, by monolithically integrating the ESD protection clamp with the normally off LV transistor on a common die, the size of the ESD protection clamp can be substantially minimized, thereby advantageously reducing gate capacitance and leakage. Similarly, by monolithically integrating the ESD protection clamp with the normally off LV transistor as well as the normally on power transistor on a common die, the parasitic inductances between the LV and HV devices can be minimized and the matching of the device capacitances can be better controlled.

From the above description it is manifest that various techniques can be used for implementing the concepts described in the present application without departing from the scope of those concepts. Moreover, while the concepts have been described with specific reference to certain implementations, a person of ordinary skill in the art would recognize that changes can be made in form and detail without departing from the scope of those concepts. As such, the described implementations are to be considered in all respects as illustrative and not restrictive. It should also be understood that the present application is not limited to the particular implementations described herein, but many rearrangements, modifications, and substitutions are possible without departing from the scope of the present disclosure.

## Claims

1. A normally off composite power device comprising:
a normally on power transistor providing a composite drain of said normally off composite power device;
a normally off low voltage (LV) transistor cascoded with said normally on power transistor, said normally off LV transistor providing a composite source and a composite gate of said normally off composite power device;
an ESD protection clamp coupled between said composite source and said composite gate, said ESD protection clamp configured to provide electrostatic discharge (ESD) protection for said normally off composite power device.

2. The normally off composite power device of claim 1, wherein said ESD protection clamp is a discrete diode that is not monolithically integrated with said normally on power transistor and said normally off LV transistor.

3. The normally off composite power device of claim 1, wherein said normally off LV transistor and said ESD protection clamp are monolithically integrated.

4. The normally off composite power device of claim 1, wherein said normally on power transistor and said normally off LV transistor and said ESD protection clamp are monolithically integrated.

5. The normally off composite power device of claim 1, wherein said normally on power transistor and said normally off LV transistor are monolithically integrated.

6. The normally off composite power device of claim 1, wherein said normally on power transistor is a high voltage (HV) group III-V transistor.

7. The normally off composite power device of claim 1, wherein said normally on power transistor comprises a III-Nitride high electron mobility transistor (HEMT).

8. The normally off composite power device of claim 1, wherein said normally off LV transistor comprises a group IV field-effect transistor (FET).

9. The normally off composite power device of claim 1, wherein said normally off LV transistor comprises a silicon FET.

10. The normally off composite power device of claim 1, wherein said normally off LV transistor and said ESD protection clamp comprise silicon devices.

11. The normally off composite power device of claim 1, wherein a drain of said normally off LV transistor is coupled to a source of said normally on power transistor, a source of said normally off LV transistor providing said composite source, and a gate of said normally off LV transistor providing said composite gate, a drain of said normally on power transistor providing said composite drain, a gate of said normally on power transistor being coupled to said source of said normally off LV transistor and to an anode of said ESD protection clamp.

12. The normally off composite power device of claim 1, wherein said ESD protection clamp comprises a combination of transistors, and/or diodes and/or resistors that are not monolithically integrated with said normally on power transistor and said normally off LV transistor.

13. The normally off composite power device of claim 1, wherein said ESD protection clamp comprises a combination of transistors, and/or diodes and/or resistors that are monolithically integrated with said normally on power transistor and said normally off LV transistor.

14. The normally off composite power device of claim 1, wherein said ESD protection clamp comprises at least one diode that is monolithically integrated with said normally on power transistor and said normally off LV transistor.

15. A monolithically integrated normally off composite power device comprising:
a normally on power transistor providing a composite drain of said normally off composite power device;
a normally off low voltage (LV) transistor cascoded with said normally on power transistor, said normally off LV transistor providing a composite source and a composite gate of said normally off composite power device;
an ESD protection clamp coupled between said composite source and said composite gate, said ESD protection clamp configured to provide electrostatic discharge (ESD) protection for said normally off composite power device;
wherein said normally on power transistor, said normally off LV transistor, and said ESD protection clamp are monolithically integrated.
